(19) **Europäisches Patentamt / European Patent Office / Office européen des brevets**

(11) **EP 1 273 035 B1**

(12) **FASCICULE DE BREVET EUROPEEN**

(45) Date de publication et mention
de la délivrance du brevet:
**12.09.2012 Bulletin 2012/37**

(51) Int Cl.:
***H01L 21/762*** *(2006.01)*      ***B23K 26/40*** *(2006.01)*

(21) Numéro de dépôt: **01927984.3**

(86) Numéro de dépôt international:
**PCT/FR2001/001179**

(22) Date de dépôt: **17.04.2001**

(87) Numéro de publication internationale:
**WO 2001/080308 (25.10.2001 Gazette 2001/43)**

(54) **PROCEDE POUR LA DECOUPE D'AU MOINS UNE COUCHE MINCE DANS UN SUBSTRAT OU LINGOT, NOTAMMENT EN MATERIAU(X) SEMI-CONDUCTEUR(S)**

**VERFAHREN ZUM SCHNEIDEN MINDESTENS EINER DÜNNSCHICHT IN EINEM SUBSTRAT ODER IN EINEM ROHBLOCK, INSBESONDERE AUS HALBLEITERMATERIAL**

**METHOD FOR CUTTING OUT AT LEAST A THIN LAYER IN A SUBSTRATE OR INGOT, IN PARTICULAR MADE OF SEMICONDUCTOR MATERIAL(S)**

(84) Etats contractants désignés:
**AT BE CH CY DE DK ES FI FR GB GR IE IT LI LU MC NL PT SE TR**

(30) Priorité: **14.04.2000 FR 0005549**

(43) Date de publication de la demande:
**08.01.2003 Bulletin 2003/02**

(73) Titulaire: **Soitec**
**38190 Bernin (FR)**

(72) Inventeur: **ROCHE, Michel**
**F-21000 Dijon (FR)**

(74) Mandataire: **Le Forestier, Eric et al**
**Cabinet Regimbeau**
**20, rue de Chazelles**
**75847 Paris Cedex 17 (FR)**

(56) Documents cités:
**EP-A- 0 792 731    EP-A- 0 961 312**
**FR-A- 2 666 759**

- **PATENT ABSTRACTS OF JAPAN vol. 2000, no. 02, 29 février 2000 (2000-02-29) & JP 11 312811 A (SEIKO EPSON CORP), 9 novembre 1999 (1999-11-09) -& EP 1 014 452 A (SEIKO EPSON CORPORATION) 28 juin 2000 (2000-06-28)**
- **YOUTSOS A G, KIRIAKOPOULOS M, TIMKE TH: "Experimental and theoretical/numerical investigations of thin films bonding strength" THEORETICAL AND APPLIED FRACTURE MECHANICS, vol. 31, no. 1, février 1999 (1999-02) - mars 1999 (1999-03), pages 47-59, XP001031851**
- **DATABASE WPI Section Ch, Week 199317 Derwent Publications Ltd., London, GB; Class L03, AN 1993-141287 XP002179817 & SU 1 324 525 A (TOMSK POLY NUCLEAR PHYS RES INST), 30 mai 1992 (1992-05-30)**

## Description

## Domaine de l'invention et état de la technique

L'invention concerne la découpe d'au moins une couche mince dans un substrat ou lingot, notamment en matériau(x) semi-conducteur(s), pour composant ou capteur électronique ou opto-électronique ou optique

Pour de nombreuses applications liées aux domaines de la micro-électroniques, de l'optoélectronique ou des capteurs, une opération technologique consistant à reporter une couche d'un substrat vers un autre représente une opération clé permettant la fabrication de nombreuses structures de matériaux ou de composants spécifiques. Cette couche à transférer peut comporter ou non des composants dont l'état d'achèvement peut être complet ou partiel.

Un exemple d'applications consiste à réaliser des substrats « Silicium Sur Isolant » ( ou encore Silicon On Insulator; SOI selon la terminologie Anglo-saxonne). L'isolant typiquement retenu est du SiO2 de structure amorphe sur lequel il n'est pas possible de réaliser un dépôt de silicium de qualité monocristalline. Une catégorie de techniques pour la réalisation de telles structures reposent sur des techniques de collage moléculaire (wafer bonding selon la terminologie Anglo-saxonne). Ces techniques sont connues de l'homme de l'art et sont notamment décrites dans l'ouvrage « Semiconductor Wafer bonding Science and Technology », (Q.-Y. Tong and U. Gösele, a Wiley Interscience publication, johnson Wiley & Sons, Inc.). Comme le décrit cet ouvrage, grâce à ces techniques, deux substrats (en général du silicium) sont assemblés, l'un étant destiné à fournir la couche « Silicium Sur Isolant » (« substrat source ») qui sera reportée sur l'autre substrat devenant ainsi le nouveau substrat support (« substrat support ») de cette couche SOI. Une couche d'isolant, typiquement de SiO2, aura au préalable été formée sur l'une au moins des faces de ces substrats avant assemblage, devenant ainsi un isolant enterré situé sous la couche SOI.

Certaines variantes sont connues sous la dénomination BSOI (Bonded SOI) ou encore BESOI (Bond and Etch Back). Ces variantes reposent, outre sur un collage comprenant l'adhésion moléculaire, sur un enlèvement physique du substrat source soit par des techniques de type polissage/rectification mécanique et/ou des techniques de gravure chimique. D'autres variantes reposent en plus du collage par adhésion moléculaire sur la séparation par "découpe" le long d'une zone fragilisée telles que les méthodes décrites dans les documents US-A-5374564 (ou EP-A-533551), US-A-6020252 (ou EP-A-807970) (séparation le long d'une zone implantée) ou encore dans le document EP 0925888 (séparation par fracture le long d'une couche enterrée porosifiée).

Ces techniques de transfert de couches présentent un caractère générique car elles permettent de réaliser des structures combinant différents types de matériaux entre eux, qu'il n'aurait pas été possible d'obtenir par ailleurs, notamment par dépôt. Des exemples sont par exemple des substrats silicium monocristallin sur quartz, des substrats AsGa sur silicium, etc... .

L'avantage de tels procédés à couche fragile enterrée est de pouvoir réaliser des couches à base de silicium cristallin (ou de SiC, InP, AsGa LiNbO3, LiTaO3...) dans une gamme d'épaisseur pouvant aller de quelques dizaines d'angström (Å) à quelques micromètres ($\mu$m), avec une très bonne homogénéité. Des épaisseurs plus élevées restent également accessibles.

Outre la réalisation de substrats, il existe de nombreux autres exemples d'applications où les techniques de report de couche peuvent fournir une solution adaptée pour l'intégration de composants ou de couches sur un support à priori inadapté à leur réalisation. Ces techniques de transfert de couches sont également très utiles lorsque l'on souhaite isoler une couche fine, avec ou sans composant, de son substrat initial, par exemple en procédant à une séparation ou élimination de ce dernier.

A titre d'exemple, de plus en plus de composants doivent être intégrés sur des supports différents de ceux permettant leur réalisation. Par exemple, on peut citer les composants sur substrats plastiques ou sur substrats souples. Par composants, on entend tout dispositif micro-électronique, optoélectronique ou capteur (par exemple chimique, mécanique, thermique, biologique ou biochimique) entièrement ou partiellement « processé », c'est à dire entièrement ou partiellement réalisé. Pour intégrer ces composants sur des supports souples (incompatibles avec leur réalisation), on peut utiliser une méthode de report de couche qui aura lieu après la réalisation des composants sur un substrat compatible avec leur réalisation..

Encore dans le même esprit, un retournement de couche fine associé à son transfert sur un autre support fournit aux ingénieurs un degré de liberté précieux pour pouvoir concevoir des structures impossibles par ailleurs. Ces prélèvements et retournements de films minces permettent par exemple de réaliser des structures dites enterrées telles que des capacités enterrées pour les DRAMs (Dynamic Random Access Memory) où, contrairement au cas usuel, les capacités sont d'abord formées puis reportées sur un autre substrat de silicium avant de reprendre la fabrication sur ce nouveau substrat du reste des circuits. Un autre exemple concerne la réalisation de structures de transistors dites à double grille. La première grille du transistor CMOS est réalisée selon une technologie conventionnelle sur un substrat puis reportée avec retournement sur un second substrat pour reprendre la réalisation de la deuxième grille et de la finition du transistor, laissant ainsi la première grille enterrée dans la structure (voir par exemple K. Suzuki, T. Tanaka, Y. Tosaka, H. Horie and T Sugii, "High-Speed and Low Power n+-p+ Double-Gate SOI CMOS", IEICE Trans. Electron., vol. E78-C, 1995, pp. 360-367).

On retrouve une situation identique par exemple dans le domaine des applications liées aux télécommunications et hyperfréquence. Dans ce cas, on préfère que les composants soient intégrés en final sur un support présentant une résistivité élevée, typiquement de plusieurs kohms.cm au moins. Mais un substrat fortement résistif n'est pas forcément disponible aux mêmes coûts et qualité que les substrats standard habituellement utilisés. Dans le cas du silicium, on peut par exemple noter la disponibilité de plaques de silicium en diamètre 200 et 300mm de résistivité standard tandis que pour des résistivités supérieures à 1kohm.cm, l'offre est très inadaptée en 200mm et inexistante en 300mm. Une solution consiste à réaliser les composants sur substrats standards puis à reporter lors des étapes finales une couche fine contenant les composants sur un substrat isolant de type verre, Quartz, sapphire, etc...

D'un point de vue technique, ces opérations de transfert ont pour intérêt majeur de décorréler les propriétés de la couche dans laquelle sont formés les composants et la couche support final, et trouvent par conséquent intérêt dans bien d'autres cas encore.

Concernant plus spécifiquement les techniques de report de couche basées sur une fracture ou séparation le long d'une zone fragilisée (fragilisation d'un point de vue mécanique au sens large) ou pré-définie pour être sélectivement à l'origine d'une séparation (par gravure chimique par exemple), plusieurs techniques quant à l'étape ou combinaison qui provoque la découpe sont connues.

Par exemple, certaines combinaisons sont plus spécifiquement basées sur une séparation à caractère mécanique (jet d'eau sous pression comme dans le document EP 0925888). Certaines techniques, basées sur le principe dit du " lift-off ", permettent également de séparer une couche mince du reste de son support initial, sans forcément consommer ce dernier. Ces méthodes utilisent généralement des attaques chimiques attaquant sélectivement une couche intermédiaire enterrée, associées ou non à des efforts mécaniques. Ce type de méthode est très utilisé pour le report d'éléments III-V sur différents types de supports (Voir : C. Camperi et al. - IEEE Transaction and photonics technology - vol 3, 12 (1991) 1123).

A titre d'autre exemple, il est décrit dans le document EP 0925888, une découpe par fracture le long d'une couche enterrée porosifiée grâce à des moyens mécaniques représentés par un jet d'eau sous pression appliqué au voisinage de la zone à découper. Un jet d'air comprimé peut également être utilisé comme il est décrit dans le document FR 2796491, où on peut encore exercer une traction comme dans le document WO 00/26000. L'insertion d'une lame peut également être un choix judicieux.

D'autres exemples reposent sur une zone fragilisée obtenue par implantation. En combinant ou non à cette implantation, les moyens spécifiques pour appliquer les efforts mécaniques cités avant (ou d'autres) et/ou des gravures chimiques et/ou des traitements thermiques etc .., une découpe peut être obtenue selon cette zone fragilisée. On trouvera quelques exemples de mise en ouvre dans les documents US-A-5374564 (ou EP-A-533551), US-A-6020252 (ou EP-A-807970) et WO 00/61841.

De nombreux moyens peuvent être adoptés pour déclencher ou assister la découpe selon une zone fragilisée. Les 4 documents US 6 020 252, US 6 013 563, EP 0 961 312 et EP 1 014 452 permettent de citer plus explicitement par exemple des forces mécaniques de tension, de cisaillement, de torsion, des traitements thermiques avec des sources de chaleur, voire de froid, de diverses nature (fours classiques, faisceaux lumineux, lasers, champs électromagnétiques, faisceaux d'électrons, fluides cryogéniques, etc ...), ablation laser d'une couche intermédiaire, etc....

En particulier, le document EP 0961312 décrit un procédé dans lequel une impulsion énergétique, réalisée au moyen d'un faisceau laser, est absorbée au voisinage d'une couche fragilisée ce qui cause un chauffage local soudain, ce qui provoque des contraintes thermiques importantes menant au clivage de la couche fragilisée.

## Problème technique et présentation de l'invention

Les techniques de transfert de couche citées au préalable présentent cependant quelques inconvénients spécifiques.

Les techniques basées sur un amincissement (mécanique , chimique etc..) ont pour inconvénient de consommer et sacrifier un substrat, ce qui d'un point de vue économique est pénalisant. Ces techniques d'amincissement sont en outre souvent assez lourdes et coûteuses à mettre en oeuvre.

Les combinaisons basées sur l'application de contraintes mécaniques externes (cisaillement, torsion, flexion, tension, ..) présentent l'inconvénient de nécessiter en général un collage (moléculaire ou autre) suffisamment résistant pour ne pas lâcher sous la contrainte nécessaire à la rupture de la zone fragilisée. Un procédé pour obtenir un tel collage, soumis pour certaines applications ou procédés de fabrication à un cahier des charges sévère (par exemple impossibilité de chauffer, impossibilité d'utiliser des solvants ou produits chimiques spécifiques, impossibilité de tirer sur la structure pour risques de destruction des composants sensibles ...) n'est pas toujours disponible

Les techniques basées sur des recuits et autres traitements thermiques se heurtent pour certaines applications à une incompatibilité d'une élévation de température avec par exemple le support final sur lequel on souhaite intégrer la couche. Par exemple, le nouveau support peut ne pas supporter les températures requises (cas d'un support plastique). A titre d'autre exemple, l'incompatibilité peut provenir de la combinaison des matériaux, notamment du fait d'une différence de coefficients de dilatation thermique trop importante qui viendrait à provoquer lors d'une montée en température la cassure d'un ensemble trop inhomogène (cas d'une structure associant deux substrats Silicium sur quartz).

Les techniques basées sur une gravure chimique peuvent se heurter, du fait de leur agressivité, à une incompatibilité vis-à-vis du support final sur lequel on souhaite intégrer la couche à transférer ou encore vis-à-vis de composants qui pourraient être présents sur cette couche.

Parmi les autres combinaisons, les documents US 6 013 563 et EP 1 014 452 décrivent ou évoquent des techniques basées sur l'application de faisceaux lumineux et/ou d'électrons.

Le document US 6 013 563 fait référence à l'application de faisceaux de photons et/ou d'électrons dans un but de chauffer la structure.

Le document EP 1 014 452 décrit un procédé dans lequel une quelconque source de photons (rayons X, lumière visible, infra-rouge, UV, micro-ondes, laser etc ...) serait susceptible de provoquer une séparation. Le mode de mise en oeuvre, décrit dans le cas de l'emploi d'un laser par exemple, fait référence à une ablation laser de cette couche intermédiaire et mène les auteurs à préférer des impulsions laser de puissance relativement élevées (« préférence la plus forte pour des densités d'énergie comprises entre 100 et 500 mJ/cm$^2$ ») et de durée relativement longues (« préférence pour des durées comprises entre 1 et 1000 ns, et préférence la plus forte pour des durées comprises entre 10 et 100 ns »). Les auteurs décrivent également que ce mode de mise en oeuvre nécessitant un apport d'énergie relativement important pour pouvoir fonctionner a comme inconvénients de pouvoir endommager la couche à transférer.

L'invention a quant à elle pour objet un mode de mise en oeuvre pour mener à une découpe le long d'une zone fragilisée qui ne repose ni sur une élévation de température, ni sur une gravure chimique, ni sur une décomposition (par ablation ou autre) de cette couche fragilisée.

Ceci est obtenu selon l'invention grâce à un procédé selon la revendication 1.

Selon ce procédé, on réalise le clivage d'une couche fragilisée en injectant dans le substrat une impulsion énergétique qui génère une onde acoustique, d'amplitude convenable pour provoquer le clivage au niveau de ladite couche fragilisée.

Un tel procédé est en outre avantageusement complété par les caractéristiques des revendications 2 et suivantes.

## Présentation des figures

Les caractéristiques et avantages de l'impulsion apparaîtront mieux dans la description qui va suivre, référencées au dessous annexes dans lesquels :

- la figure 1 représente une coupe de l'ensemble des substrats semi-conducteurs et isolants après implantation et collage

- la figure 2 représente la loi du dépôt d'énergie dans la matière dans le cas où celui-ci s'effectue avec un laser.
- la figure 3 représente l'onde acoustique à un instant donné sous forme de la courbe P(x)
- la figure 4 représente l'onde acoustique à l'arrière de la fracture sous forme de la loi P(x)
- la figure 5 représente l'appareillage de dépôt d'énergie par laser impulsion, cet appareillage ne faisant pas partie de l'invention.
- la figure 6 représente l'appareillage de dépôt d'énergie dans le cas où on utilise un faisceau d'électron pour chauffer la couche superficielle du substrat de semi-conducteur, cet appareillage ne faisant pas partie de l'invention.

## Description détaillée d'un ou plusieurs modes de réalisation

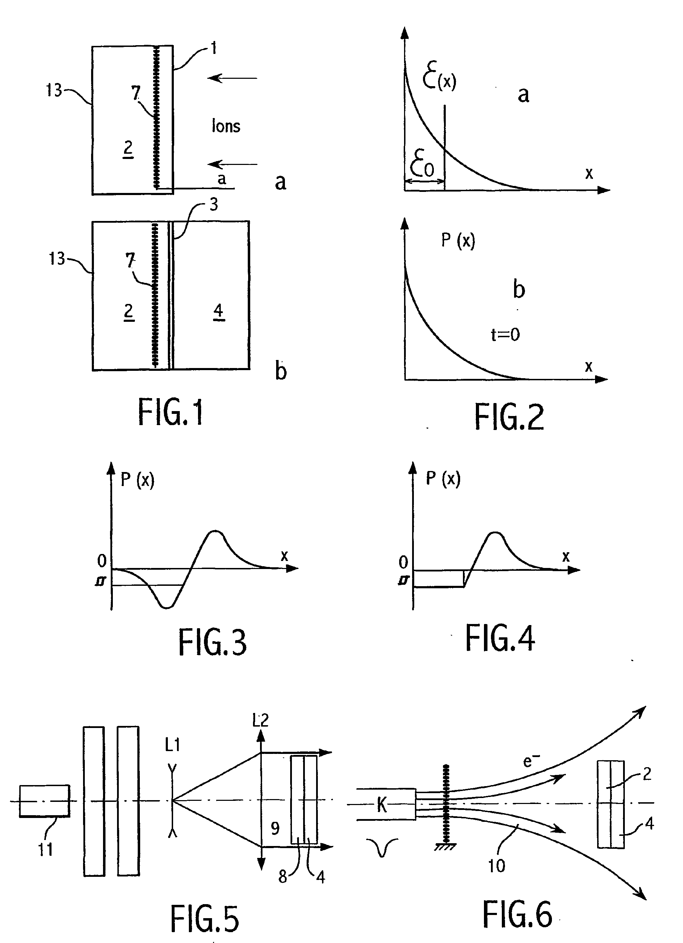

Suivant un premier mode préféré de réalisation de l'invention, on procède de la façon suivante On part d'une tranche semi-conducteur par exemple du silicium (2) (voir figure 1) d'une épaisseur de l'ordre de 500 $\mu$m, polie sur l'une de ses faces (1) et on implante sur cette face des protons ayant une énergie telle que leur profondeur de pénétration dans le semi-conducteur est un peu supérieure à l'épaisseur $\lambda$ de la couche mince de semi-conducteur que l'on souhaite réaliser. Par exemple pour réaliser une couche de l'ordre de 1 $\mu$m on utilisera une énergie de protons de l'ordre de 150 keV.

On prépare ensuite le substrat isolant (4) qui dans le cas de la figure 1 est en fait un substrat de silicium recouvert d'une couche de SiO2 d'épaisseur typique de quelques dixièmes de $\mu$ms.

On réalise ensuite le collage des substrats (4) et (2), par adhésion moléculaire suivant une procédure maintenant bien connue (voir par exemple l'ouvrage « Semiconductor Wafer bonding Science and Technology », Q.-Y. Tong and U. Gösele, a Wiley Interscience publication, johnson Wiley & Sons, Inc.).

On obtient ainsi le bloc représenté sur la figure 1-b. Ce bloc est ensuite chauffé impulsionnellement à partir de la surface libre de la tranche de semi-conducteur (2), c'est à dire la face (13) représentée sur la figure 1-b. Le but du chauffage est de provoquer une montée en pression dans l'épaisseur $\varepsilon_0$ affectée par le chauffage, ceci est en effet nécessaire pour générer l'onde acoustique qui sera utilisée pour provoquer la rupture de la couche implantée (7) fragilisée par l'implantation ou tout autre moyen. Pour le chauffage de la couche sous la surface (13), d'épaisseur $\varepsilon_0$, il est nécessaire de réaliser ou de s'approcher des conditions de "chauffage à volume constant". Le chauffage provoque une dilatation mais celle-ci ne peut se réaliser que par une onde acoustique qui se propage à la vitesse du son. Si le chauffage s'effectue en temps t inférieur au temps que met l'onde sonore pour traverser la moitié de l'épaisseur de la couche chauffée (dont l'épaisseur est égale à $\varepsilon_0$ ), on conçoit aisément que le centre de cette couche n'a pas pu se détendre pendant toute la durée du chauffage. Celui-ci a donc été effectué à "volume constant", à condition de respecter la relation ci-dessous : C étant la vitesse du son

$$ t < \frac{\varepsilon_0}{2C} $$

Les ordres de grandeur impliqués dans cette relation sont dominés par la nécessité de réaliser une onde acoustique très brève spatialement.

On considère en l'occurrence que ceci est vérifié dès lors que la durée de l'impulsion énergétique sera nférieure à ou de l'ordre de la durée nécessaire à une onde acoustique pour traverser l'épaisseur de la zone absorbant l'énergie de ladite impulsion, ladite impulsion étant d'une énergie choisie pour provoquer un clivage au niveau de ladite couche fragilisée.

Pour que le mécanisme de rupture soit efficace, il faut que $\varepsilon_0$ soit de l'ordre de grandeur de l'épaisseur $\lambda$ de la couche à détacher qui est de l'ordre de 1 micromètre. On sait par ailleurs que dans un semi-conducteur, le silicium par exemple, la vitesse du son est de l'ordre de $210^3$ m.s$^{-1}$. La relation ci-dessus nous indique donc que la durée d'impulsion doit être de l'ordre de ou inférieure à 1ns et préférentiellement inférieure à 0.5 ns, ce qui est extrêmement bref mais susceptible d'être atteint au moyen de lasers spéciaux ou de faisceaux d'électrons.

Dès que les conditions ci-dessus sont atteintes, on peut exprimer l'amplitude $\Delta P$ de l'onde acoustique, en compression ou en détente, par la relation de Grüneisen :

$$ \Delta P = \frac{1}{2} \Gamma \cdot \rho \cdot \frac{dE}{dm} $$

Dans laquelle $\Gamma$ est le coefficient de Grüneisen. pour le Silicium, il est de l'ordre de 1.5 ; $\rho$ est la densité du milieu, elle est de l'ordre de $2.5\ 10^3$ (S.I.).

$\dfrac{dE}{dm}$ est la variation de l'énergie interne spécifique du milieu. Elle est égale au chauffage impulsionnel ramené à l'unité de masse.

Admettons par exemple que le chauffage impulsionnel entraîne une élévation de température $\Delta\theta = 75°C$. dans du silicium ayant une chaleur spécifique de 0.75 joule par gramme, on a alors $\dfrac{dE}{dm}$ = $5.62\ 10^4$ (S.I.)

En reportant ces valeurs dans la formule ci-dessus, on trouve une pression typique de 105 MP soit encore 1.05 kbar. On remarquera que cette amplitude d'onde lorsqu'elle s'exerce sous forme de détente est de l'ordre de grandeur de la cohésion de la matière et qu'elle est donc de nature à provoquer la rupture d'une couche fragilisée par l'implantation ionique. Notons enfin qu'une pression aussi élevée n'est obtenue que par un échauffement modeste de 75°C au niveau du point où l'énergie est déposée et que, dès que cette énergie se disperse dans l'épaisseur du substrat, l'échauffement devient inférieur à 1°C. On peut donc réellement parler d'un procédé de délaminage à froid.

La forme de l'onde acoustique dépend de la répartition du dépôt d'énergie dans la matière. Si le dépôt d'énergie s'effectuait en un temps nul et si sa répartition $\varepsilon(x)$ en fonction de la profondeur x dans le semi-conducteur (2) avait l'allure exponentielle schématisée sur la figure 2-a, on aurait à cet instant une pression P(x) représentée sur la courbe de la figure 2-b. En réalité, la distribution Po(x) est déformée par la prorogation des détentes pendant la durée du dépôt (qui n'est jamais instantané).

Cette pression initiale se sépare en deux ondes, l'une part vers l'arrière (sens x croissant) l'autre part en direction inverse, se réfléchit sur la face libre et revient en arrière mais cette fois sous forme d'onde de détente. La figure 3 représente l'onde complète à un instant donné, au cours de sa propagation dans le milieu (2). On remarquera que l'impulsion totale, c'est à dire la surface sous la courbe est nulle, ce qui est nécessaire car le faisceau laser ou d'électrons, responsable du chauffage à une impulsion quasi nulle. Lorsque l'onde de détente traverse la couche implantée dont on supposera que la contrainte de rupture est T, l'onde transmise en aval est tronquée ainsi que schématisé sur la figure 4. Ainsi, l'impulsion reçue par la couche (5) et son support (4) n'est pas nulle, ce qui provoque une éjection à faible vitesse de cette masse.

Examinons maintenant comment s'effectue le chauffage impulsionnel de la face (13). On a vu que l'épaisseur chauffée devait être de l'ordre de 1 $\mu$m, ce qui correspond à une masse de matière de l'ordre de $2.5\ 10^{-4}$ g par cm$^2$. Il faudra donc pour atteindre l'échauffement impulsionnel de 75°C évoqué plus haut que la densité d'énergie dans le faisceau soit de l'ordre de $1.87\ 10^{-4}$ joule par cm$^2$. Cette énergie théorique est très faible. En effet pour décoller une couche sur un wafer de Ø 300 mm, il suffirait d'une énergie dans l'impulsion laser ou faisceau d'électrons de 0.13 joules (!).

En réalité, on devra mettre en oeuvre une énergie plus élevée en raison de la détente qui se manifeste pendant le dépôt d'énergie et aussi en raison du fait que l'absorption n'est pas idéale, c'est à dire qu'elle comporte une queue de distribution qui est inefficace pour la montée en pression. En pratique l'énergie nécessaire pour décoller une lame sur Ø 300 mm sera de l'ordre de 13 joules. Pour déposer l'énergie requise dans la surface (13), on peut soit utiliser un laser à impulsion très brèves comme par exemple un laser YAG utilisant un ou deux étages d'amplification et un pilote Q switché avec raidissement du front par lame saturables de façon à réaliser des impulsions de 0.1 à 1 ns de durée. Pour des énergies par impulsion plus élevées les derniers étages d'amplification peuvent être constitués par du verre au néodyme. On obtient alors en utilisant un schéma du type de celui représenté sur la figure 5. Un système de lentilles L1, L2 permet d'apodiser le faisceau (9) de façon à ce que la densité d'énergie soit parfaitement uniforme sur toute la surface (13) dont le diamètre peut atteindre, dans les technologies actuelles 300 mm. Ce dispositif étant réalisé, il faut coupler le faisceau laser dont la longueur d'onde est voisine de 1.06 $\mu$m au semi-conducteur constituant le substrat (2). Dans le cas du silicium, si on utilisait directement le faisceau à 1.06 $\mu$m, l'absorption se ferait sur une épaisseur moyenne de l'ordre de 100 $\mu$m, ce qui est beaucoup trop important. Pour réduire l'épaisseur du dépôt d'énergie, il faut augmenter l'absorption du milieu (2). Ceci peut se faire

    1) en doublant, triplant, quadruplant la fréquence du faisceau laser suivant des techniques à base de lames à effets non linéaires maintenant bien connues,
    2) en dopant superficiellement par exemple par implantation ionique de phosphore ou d'arsenic pour en diminuer la résistivité et donc augmenter son absorption à la longueur d'onde de 1 $\mu$m,
    3) en déposant sur la face (13) une couche mince absorbante, par exemple une couche métallique de 1 $\mu$m d'épaisseur.

Pour déposer l'énergie, on peut également utiliser un faisceau impulsionnel d'électrons (10) (voir figure 6), obtenu à partir d'une diode pulsée (12). Pour que la pénétration dans (2) soit de l'ordre de 1 $\mu$m, l'énergie des électrons devra être limitée aux environs de 30 keV. Pour déposer sur une surface de Ø 300 mm une énergie de l'ordre de 3 joules compte tenu de la meilleure absorption par le milieu (2), le courant débité dans la diode devra être de 150 kA, ce qui est réalisable.
Suivant un autre mode préféré de réalisation de l'invention, on dépose l'énergie au moyen d'un faisceau laser à 1.06 $\mu$m tel que celui décrit plus haut, directement dans la couche implantée (7) où on souhaite réaliser la fracture du semi-conducteur (2). On se placera dans le cas où ledit semi-conducteur (2) est constitué par du silicium. Etant donné que celui-ci est assez transparent à la longueur d'onde du YAG, on peut atteindre, au centre de l'empilement (2), (4), la couche (7) en l'éclairant soit par la face (13), soit par la face opposée. On profite de ce que la couche implantée est naturellement beaucoup plus absorbante que le cristal initial, même dans le cas d'une implantation par des protons. On peut d'ailleurs augmenter fortement son absorption en implantant des ions phosphore ou arsenic ou tout autre élément convenable. On notera que dans ce cas, l'onde de détente créée est environ deux fois, tous paramètres identiques par ailleurs, à ce qu'on a obtenu dans le cas précédent. Par ailleurs, la mise en oeuvre est simplifiée puisqu'on a plus à se préoccuper du parallélisme entre la couche où l'énergie est déposée et la couche implantée puisqu'elles coïncident. Cette disposition présente en outre l'avantage de ne pas nécessiter d'opération de collage dont la résistance à la traction devrait être forte. En effet chacune des deux parties résultant du clivage de la couche implantée (7) reçoit une impulsion nette. En d'autres termes l'interface de collage (3) n'est plus soumis qu'à une onde de compression, pour autant bien entendu qu'on dispose sur la face opposée à la surface (13) un milieu adapté mécaniquement permettant de recevoir l'onde acoustique de compression afin d'éviter qu'elle ne se réfléchisse en détente sur cette face. Cet amortisseur peut être constitué par une lame de silice de 10 ou 20 mm d'épaisseur collé définitivement ou temporairement sur la face opposée à (13).
L'invention peut être utilisée pour la fabrication industrielle de substrat de type S.O.I.

**Revendications**

1.  Procédé pour la découpe d'au moins une couche mince dans un élément (2) formant substrat ou lingot pour composant ou capteur électronique ou opto-électronique ou optique, mettant en oeuvre les étapes consistant à :

    - former dans ledit élément (2) une zone fragilisée (7) à une profondeur correspondant à l'épaisseur de la couche que l'on veut découper ;
    - appliquer à partir de l'une des faces parfaitement polies dudit élément (2) une impulsion énergétique qui génère une onde acoustique, ladite impulsion présentant une durée inférieure à ou de l'ordre de la durée nécessaire à l'onde acoustique pour traverser l'épaisseur de la zone absorbant l'énergie de ladite impulsion, et une énergie choisie pour provoquer un clivage au niveau de ladite zone fragilisée (7).

2.  Procédé selon la revendication 1, **caractérisé en ce que** la zone fragilisée est une couche poreuse.

3.  Procédé selon la revendication 1, **caractérisé en ce que** la zone fragilisée est formée par implantation.

4.  Procédé selon la revendication 3, **caractérisé en ce que** l'implantation est une implantation de phosphore et/ou d'arsenic et/ou de protons et/ou de gaz rares.

5.  Procédé selon l'une des revendications précédentes, **caractérisé en ce que** l'élément formant substrat ou lingot est en matériau(x) semi-conducteur(s) et/ou $LiNbO_3$ et/ou $LiTaO_3$ ou en un matériau composé à base de ces matériaux.

6.  Procédé selon la revendication 5, **caractérisé en**

**ce que** l'élément formant substrat ou lingot est en silicium et/ou SiC et/ou GaAs et/ou InP et/ou GaN et/ou SiGe et/ou LiNbO$_3$ et/ou LiTaO$_3$ ou en un matériau composé à base de ces matériaux.

7. Procédé selon l'une des revendications précédentes, **caractérisé en ce que** l'on colle, après l'étape de fragilisation, ledit élément sur un autre support, l'impulsion énergétique étant injectée dans le bloc ainsi obtenu.

8. Procédé selon la revendication 7, **caractérisé en ce que** le collage est un collage de type collage moléculaire ou au moyen d'une colle adhésive.

9. Procédé selon l'une des revendications 7 ou 8, **caractérisé en ce que** le bloc issu du collage comporte une couche de SiO$_2$, de Si$_3$N$_4$ ou une combinaison de ces deux matériaux.

10. Procédé selon l'une des revendications précédentes, **caractérisé en ce que** le dépôt d'énergie impulsionnel est réalisé au moyen d'un faisceau laser ou d'un faisceau d'électrons.

11. Procédé selon l'une des revendications précédentes, **caractérisé en ce que** la durée d'une impulsion est inférieure à 1 ns.

12. Procédé selon l'une des revendications précédentes, **caractérisé en ce que** l'impulsion est une impulsion unique.

13. Procédé selon l'une des revendications précédentes, **caractérisé en ce que** l'impulsion est répétée plusieurs fois.

14. Procédé selon la revendication 3 prise seule ou en combinaison avec l'une des revendications 4 à 13, **caractérisé en ce que** le dépôt d'énergie impulsionnel est réalisé à partir de la face par laquelle s'effectue l'implantation.

15. Procédé selon la revendication 3 prise seule ou en combinaison avec l'une des revendications 4 à 13, **caractérisé en ce que** le dépôt d'énergie impulsionnel est réalisé à partir de la face opposée à celle par laquelle est réalisée l'implantation.

16. Procédé selon l'une des revendications précédentes, **caractérisé en ce que** le dépôt d'énergie impulsionnel est réalisé par absorption sélective directement sur la zone fragilisée ou en son voisinage.

17. Procédé selon la revendication 16, **caractérisé en ce que** le caractère absorbant sélectif est réalisé par dopage.

18. Procédé selon la revendication 16, **caractérisé en ce que** l'absorption sélective est réalisée dans une couche métallique.

19. Procédé selon la revendication 18, **caractérisé en ce que** l'absorption sélective est obtenue au sein d'une couche déposée.

20. Procédé selon la revendication 18, **caractérisé en ce que** l'absorption sélective est obtenue au sein d'une couche dont les propriétés ont été modifiées par implantation.

21. Procédé selon l'une des revendications précédentes, **caractérisé en ce que** le dépôt d'énergie impulsionnel est réalisé après que tout ou partie d'un composant soit réalisé.

22. Procédé pour la réalisation d'un composant ou capteur électronique ou opto-électronique ou optique, **caractérisé en ce qu'**il met en oeuvre le procédé selon l'une des revendications précédentes.

**Claims**

1. Method for cutting at least one thin layer from a substrate or ingot forming element (2) for an electronic or optoelectronic or optical component or sensor, the method implementing the following steps:

   - forming a weak zone (7) in said element (2), the thickness of the weak zone corresponding to the thickness of the layer that is to be cut off;
   - injecting from one of the perfectly polished faces of said element (2) an energy pulse generating a sound wave, said pulse being of a shorter duration than or of a duration of the same order as the duration needed by the sound wave to pass through the thickness of the zone absorbing the energy of said pulse, and an energy that is selected to cause cleavage to take place at said weak zone (7).

2. Method according to claim 1, **characterised in that** the weak zone is a porous layer.

3. Method according to claim 1, **characterised in that** the weak zone is formed by implantation.

4. Method according to claim 3, **characterised in that** the implantation is implantation of phosphorus and/or arsenic and/or protons and/or rare gases.

5. Method according to any of the above claims, **characterised in that** the substrate or ingot forming element is made of semiconductor material(s) and/or LiNbO$_3$ and/or LiTaO$_3$ or of a composite material based on these materials.

**6.** Method according to claim 5, **characterised in that** the substrate or ingot forming element is made of silicon and/or SIC and/or GaAs and/or InP and/or GaN and/or SiGe and/or $LiNbO_3$ and/or $LiTaO_3$ or a composite material based on these materials.

**7.** Method according to any of the above claims, **characterised in that**, after the weakening step, said element is bonded onto another support, the energy pulse being injected into the resulting block.

**8.** Method according to claim 7, **characterised in that** the bonding is bonding of the molecular adhesion type or by means of an adhesive glue.

**9.** Method according to any of claims 7 or 8, **characterised in that** the block resulting from said bonding includes a layer of $SiO_2$, of $Si_3N_4$ or a combination of these two materials.

**10.** Method according to any of the above claims, **characterised in that** the energy pulse is deposited by means of a laser beam or a beam of electrons.

**11.** Method according to any of the above claims, **characterised in** the duration of a pulse is less than 1 ns.

**12.** Method according to any of the above claims, **characterised in that** the pulse is a single pulse.

**13.** Method according to any of the above claims, **characterised in that** the pulse is repeated a plurality of times.

**14.** Method according to claim 3 taken on its own or in combination with any of claims 4 to 13, **characterised in that** the energy pulse is deposited via the same face as that through which implantation takes place.

**15.** Method according to claim 3 taken on its own or in combination with any of claims 4 to 13, **characterised in that** the energy pulse is deposited via the face opposite the face through which implantation is performed.

**16.** Method according to any of the above claims, **characterised in that** the energy pulse is deposited by selective absorption directly on the weak zone or the vicinity thereof.

**17.** Method according to claim 16, **characterised in that** the selectively absorbent nature is obtained by doping.

**18.** Method according to claim 16, **characterised in that** the selective absorption is performed in a metal layer.

**19.** Method according to claim 18, **characterised in that** the selective absorption is obtained within a deposited layer.

**20.** Method according to claim 18, **characterised in that** the selective absorption is obtained within a layer wherein the properties have been modified by implantation.

**21.** Method according to any of the above claims, **characterised in that** the energy pulse is deposited after all or part of a component has been made.

**22.** Method for making an electronic or optoelectronic or optical component or sensor, **characterised in that** it implements the method according to any of the above claims.

**Patentansprüche**

**1.** Verfahren zum Abtrennen wenigstens einer Dünnschicht von einem Element (2), das ein Substrat oder einen Rohblock bildet, für eine elektronische oder optoelektronische oder optische Komponente oder einen entsprechenden Sensor, das die Schritte einsetzt, die aus Folgendem bestehen:

- Ausbilden einer Schwächungszone (7) in dem Element (2) in einer Tiefe, die der Dicke der Schicht entspricht, die abgetrennt werden soll;
- Anwenden eines Energieimpulses, der eine akustische Welle erzeugt, und dies über eine der Flächen des Elements (2), die perfekt poliert ist, wobei der Impuls eine Dauer hat, die kürzer oder in der Größenordnung der Dauer ist, die die akustische Welle zum Durchqueren der Dicke der Zone benötigt, die die Energie des Impulses aufnimmt, und eine Energie hat, die so gewählt wird, dass im Bereich der Schwächungszone (7) eine Spaltung verursacht wird.

**2.** Verfahren nach Anspruch 1, **dadurch gekennzeichnet, dass** die Schwächungszone eine poröse Zone ist.

**3.** Verfahren nach Anspruch 1, **dadurch gekennzeichnet, dass** die Schwächungszone durch Implantation gebildet wird.

**4.** Verfahren nach Anspruch 3, **dadurch gekennzeichnet, dass** die Implantation eine Implantation von Phosphor und/oder Arsen und/oder Protonen und/oder Edelgasen ist.

5. Verfahren nach einem der vorhergehenden Ansprüche, **dadurch gekennzeichnet, dass** das Element, das das Substrat oder den Rohblock bildet, aus einem oder mehreren Halbleitermaterialien und/oder $LiNbO_3$ und/oder $LiTaO_3$ oder aus einem zusammengesetzten Material auf Basis dieser Materialien besteht.

6. Verfahren nach Anspruch 5, **dadurch gekennzeichnet, dass** das Element, das das Substrat oder den Rohblock bildet, aus Silizium und/oder SiC und/oder GaAs und/oder InP und/oder GaN und/oder SiGe und/oder $LiNbO_3$ und/oder $LiTaO_3$ oder aus einem zusammengesetzten Material auf Basis dieser Materialien besteht.

7. Verfahren nach einem der vorhergehenden Ansprüche, **dadurch gekennzeichnet, dass** nach dem Schwächungsschritt das Element auf einen weiteren Träger geklebt wird, wobei der Energieimpuls in den so erhaltenen Block abgegeben wird.

8. Verfahren nach Anspruch 7, **dadurch gekennzeichnet, dass** das Kleben ein Kleben vom molekularen Typ ist oder mittels eines Haftklebstoffs ausgeführt wird.

9. Verfahren nach einem der Ansprüche 7 oder 8, **dadurch gekennzeichnet, dass** der aus der Verklebung entstehende Block eine Schicht aus $SiO_2$, $Si_3N_4$ oder einer Kombination dieser beiden Materialien umfasst.

10. Verfahren nach einem der vorhergehenden Ansprüche, **dadurch gekennzeichnet, dass** das Zuführen der impulsartigen Energie mittels eines Laserstrahls oder eines Elektronenstrahls ausgeführt wird.

11. Verfahren nach einem der vorhergehenden Ansprüche, **dadurch gekennzeichnet, dass** die Dauer eines Impulses kürzer als 1 ns ist.

12. Verfahren nach einem der vorhergehenden Ansprüche, **dadurch gekennzeichnet, dass** der Impuls ein einziger Impuls ist.

13. Verfahren nach einem der vorhergehenden Ansprüche, **dadurch gekennzeichnet, dass** der Impuls mehrmals wiederholt wird.

14. Verfahren nach Anspruch 3 allein oder in Verbindung mit einem der Ansprüche 4 bis 13, **dadurch gekennzeichnet, dass** das Zuführen der impulsartigen Energie über die Fläche vorgenommen wird, über die die Implantation ausgeführt wird.

15. Verfahren nach Anspruch 3 allein oder in Verbindung mit einem der Ansprüche 4 bis 13, **dadurch gekenn-** zeichnet, dass das Zuführen der impulsartigen Energie über die Fläche vorgenommen wird, die derjenigen gegenüberliegt, über die die Implantation ausgeführt wird.

16. Verfahren nach einem der vorhergehenden Ansprüche, **dadurch gekennzeichnet, dass** das Zuführen der impulsartigen Energie durch selektive Absorption direkt in der Schwächungszone oder in deren Umgebung ausgeführt wird.

17. Verfahren nach Anspruch 16, **dadurch gekennzeichnet, dass** die selektiv absorbierende Eigenschaft durch Dotierung realisiert wird.

18. Verfahren nach Anspruch 16, **dadurch gekennzeichnet, dass** die selektive Absorption in einer metallischen Schicht realisiert wird.

19. Verfahren nach Anspruch 18, **dadurch gekennzeichnet, dass** die selektive Absorption innerhalb einer aufgetragenen Schicht erreicht wird.

20. Verfahren nach Anspruch 18, **dadurch gekennzeichnet, dass** die selektive Absorption innerhalb einer Schicht erreicht wird, deren Eigenschaften durch Implantation verändert wurden.

21. Verfahren nach einem der vorhergehenden Ansprüche, **dadurch gekennzeichnet, dass** das Zuführen der impulsartigen Energie ausgeführt wird, nachdem eine Komponente vollständig oder teilweise realisiert wurde.

22. Verfahren zum Herstellen einer elektronischen oder optoelektronischen oder optischen Komponente oder eines entsprechenden Sensors, **dadurch gekennzeichnet, dass** es das Verfahren nach einem der vorhergehenden Ansprüche einsetzt.

FIG.1

FIG.2

FIG.3

FIG.4

FIG.5

FIG.6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5374564 A
- EP 533551 A
- US 6020252 A
- EP 807970 A
- EP 0925888 A
- FR 2796491
- WO 0026000 A
- WO 0061841 A
- US 6013563 A
- EP 0961312 A
- EP 1014452 A

**Littérature non-brevet citée dans la description**

- **Q.-Y. TONG ; U. GÖSELE.** Semiconductor Wafer bonding Science and Technology. Wiley Interscience publication, johnson Wiley & Sons, Inc,
- **K. SUZUKI ; T. TANAKA ; Y. TOSAKA ; H. HORIE ; T SUGII.** High-Speed and Low Power n+-p+ Double-Gate SOI CMOS. *IEICE Trans. Electron.,* 1995, vol. E78-C, 360-367
- **C. CAMPERI et al.** *IEEE Transaction and photonics technology,* 1991, vol. 3 (12), 1123